# EUROPÄISCHE PATENTSCHRIFT

(11) **EP 2 936 684 B1**
(45) Veröffentlichungstag und Bekanntmachung des Hinweises auf die Patenterteilung: **29.03.2017**
(21) Anmeldenummer: 13811470.7
(22) Anmeldetag: 18.12.2013
(51) Int. Cl.: H03K 17/96

(54) **HAUSHALTSGERÄT MIT KAPAZITIVEM BEDIENPANEL UND VERFAHREN ZU SEINER HERSTELLUNG**
HOUSEHOLD DEVICE WITH CAPACITIVE OPERATING PANEL AND METHOD FOR THE PRODUCTION THEREOF
APPAREIL DOMESTIQUE PRÉSENTANT UN PANNEAU DE COMMANDE CAPACITIF ET PROCÉDÉ POUR SA FABRICATION

(30) Priorität: 19.12.2012 DE 102012223779
(43) Veröffentlichungstag der Anmeldung: 28.10.2015
(73) Patentinhaber: BSH Hausgeräte GmbH, 81739 München (DE)
(72) Erfinder: AZIZ, Abdul, 93059 Regensburg (DE); SCHMID, Erich, 93173 Wenzenbach (DE); SPITZNER, Thomas, 93149 Nittenau (DE); VOGELSANG, Peter, 93049 Regensburg (DE); ZEI, Carsten, 93161 Sinzing (DE)
(86) Internationale Anmeldenummer: PCT/EP2013/077038
(87) Internationale Veröffentlichungsnummer: WO 2014/095964

(56) Entgegenhaltungen:
- EP-A2- 1 970 479
- EP-A2- 2 385 630
- DE-A1- 10 234 125
- DE-A1-102007 006 506
- DE-A1-102009 033 538
- DE-A1-102010 063 280
- JP-A- 2010 165 618
- US-A1- 2011 012 845

## Beschreibung

Die Erfindung betrifft ein Haushaltsgerät mit einem kapazitiven Bedienpanel sowie ein Verfahren zu seiner Herstellung. Die Erfindung betrifft insbesondere ein Haushaltsgerät mit einer Steuereinrichtung, einer mindestens teilweise lichtdurchlässigen Blende sowie mit einem mindestens teilweise lichtdurchlässigen Bedienpanel mit mindestens einem kapazitiven Sensor zur Auswahl einer Programmfunktion des Haushaltsgerätes durch einen Benutzer des Gerätes sowie ein Verfahren zur Herstellung dieses Haushaltsgerätes.

Haushaltsgeräte weisen im Allgemeinen ein Bedienpanel auf, das die Möglichkeit der Einstellung von im Haushaltsgerät durchzuführenden Programmen bietet, sowie eine Darstellung von Informationen über die Durchführung eines ausgewählten Programms. Haushaltsgeräte sind hierbei beispielsweise Wäschebehandlungsgeräte wie Waschmaschinen, Trockner und Waschtrockner, Geschirrspülmaschinen, Mikrowellengeräte, Backöfen und -herde, Mixgeräte, Kaffeemaschinen usw. Die Darstellung von Informationen und ausgewählten Programmen erfolgt hierbei im Allgemeinen über ein optisches Display, bei dem oft einzelnen Displayteilbereichen zugeordnete Programme durch Beleuchtung der Displayteilbereiche hervorgehoben und damit insbesondere deren Durchführung angezeigt werden kann.

So beschreibt die DE 10 2007 048 222 A1 einen berührungsempfindlichen Bildschirm in Drucktechnik, bei dem mindesten eine kapazitive Sensortaste als Flächenelektrode auf einer transparenten Trägerplatte in Drucktechnik hergestellt ist, wobei die transparente Trägerplatte insbesondere aus Glas oder Kunststoff ist und die Flächenelektroden mit transparentem Leitlack auf der der Bedienungsseite gegenüberliegenden Rückseite der transparenten Trägerplatte gedruckt werden.

Die DE 10 2009 045 665 A1 beschreibt eine Bedieneinrichtung für ein Haushaltsgerät mit einer berührsensitiven Bedienfläche, einer Anzeigeeinheit, und einem Distanzrahmen, durch welche die Bedienfläche und die Anzeigeeinheit beabstandet voneinander angeordnet sind, wobei der Distanzrahmen einstückig mit einem Gehäuseteil eines Gehäuses der Bedieneinrichtung ausgebildet ist.

Das chinesische Gebrauchsmuster CN00020117490Y beschreibt eine Bedieneinrichtung für ein Haushaltsgerät, das mit einem berührungsempfindlichen Schalter ausgestattet ist, das ein semitransparentes Panel sowie einen leitfähigen Film, der Berührungen in elektrische Signale umwandelt, innerhalb des semitransparenten Panels umfasst.

Bei derartigen Bildschirmen bzw. Bedieneinrichtungen ist es generell erwünscht, die Montage zu vereinfachen und insbesondere die Anzahl der Montageschritte zu reduzieren. Außerdem sind solche Bedieneinrichtungen vorzuziehen, bei denen der Anschluss an eine Leiterplatte mit einer Auswerteeinheit für Berührungen eines Bedienpanels möglichst einfach vorgenommen werden kann.
Die EP 1 970 479 A2 beschreibt ein Kontrollpanel zur Regelung eines Betriebes eines Gerätes, wobei das Kontrollpanel umfasst: eine semitransparente Abdeckung; einen Film, der hinter der semitransparenten Abdeckung angeordnet ist und mit einer Vielzahl von Charakteren oder Symbolen bedruckt ist; ein detektierendes Panel, das hinter dem Film angeordnet ist und eine Vielzahl von detektierenden Mitgliedern hat, um eine Kapazität eines menschlichen Körpers zu detektieren; eine Leiterplatine, welche eine Licht emittierende Einheit hat, welche Licht auf den Film strahlt, um die Charaktere oder die Symbole des Filmes auf einer hinteren Oberfläche des semitransparenten Abdeckteils anzuzeigen; und ein Führungsteil, mit einer Vielzahl von optischen Wegen, die das von der Licht emittierenden Einheit abgestrahlte Licht in jeden der Charaktere oder Symbole des Films leiten.

Die EP 2 385 630 A2 beschreibt einen kapazitiven Berührungsschalter, umfassend: ein transparentes isolierendes Panel, eine filternde Schicht, welche eine opake Farbe hat, wobei in der filternden Schicht ein transparentes Piktogramm definiert ist; ein transparentes Substrat, das eine kapazitive Elektrode beinhaltet und gefärbt ist, um im Wesentlichen auf die opake Farbe der filtrierenden Schicht abgestimmt zu sein; und eine Lichtquelle, die konfiguriert ist, um Licht durch das transparente Substrat, das transparente Piktogramm und das transparente Panel zu leiten.

Die DE 10 2010 063 280 A1 beschreibt ein Bedienelement mit kapazitivem Sensor, um beispielsweise bei Annäherung eine Funktionsanzeige und/oder Hinterleuchtung zu aktivieren, das aufweist: einen Taster oder Druckschalter für eine Schaltfunktionalität, ein eine Bedienfläche definierender Folienschichtaufbau, wobei durch Drücken auf die Bedienfläche der Taster oder Druckschalter betätigt wird und der Folienschichtäufbau wenigstens eine Folie, beispielsweise eine Polycarbonatfolie, und eine auf die Folie aufgebrachte leitende Schicht zur Bereitstellung von wenigstens einer Elektrode des kapazitiven Sensors umfasst.

Die DE 102 34 125 A1 beschreibt ein beleuchtbares Kunststoffspritzgussteil mit einer Anzeigefunktion, das einen ersten, sichtbaren Oberflächenbereich mit einer Folie und einen zweiten Oberflächenbereich aufweist. Mit dem Kunststoffspritzgussteil ist eine Elektrolumineszenzfolie verbunden. Zur Herstellung wird zunächst durch Hinterspritzen der Elektrolumineszenzfolie mit einem metallisierbaren, thermoplastischen Kunststoffmaterial in einem Spritzgießwerkzeug ein Kunststoffformteil hergestellt.

Die DE 10 2009 033 538 A1 beschreibt eine Bedieneinrichtung für ein Elektrogerät, wobei die Bedieneinrichtung eine Bedienblende, eine Leuchtanzeige und einen Berührungsschalter samt einem flächigen, druckempfindlichen Sensorelement aufweist, wobei die Bedienblende mindestens eine Öffnung aufweist, die mit einem lichtdurchlässigen Fenster verschlossen ist, wobei an der Rückseite der Bedienblende ein flacher Bauteilträger angeordnet ist, der auf einer Seite Leuchtmittel aufweist und auf einer von der Bedienblende weg weisenden Rückseite mindestens das flächige Sensorelement im Bereich oder nahe der mindestens einen Öffnung. Dabei wird ein Lichtleiterbauteil an ein Bauteil mit Kunststoff angespritzt.

Die DE 10 2007 006 506 A1 beschreibt ein Betätigungselement für einen Funktionsträger in einem Kraftfahrzeug, umfassend ein Trägerelement; ein auf dem Trägerelement aufgebrachtes piezoelektrisches Element; eine lichtdurchlässige Schicht über dem Trägerelement sowie dem piezoelektrischen Elementschalter; sowie eine auf der lichtdurchlässigen Schicht angeordnete Dekorschicht, wobei das piezoelektrische Element relativ zur Dekorschicht geneigt ist und durch eine externe Lichtquelle, vorzugsweise eine LED, beleuchtbar ist. In einer Ausführungsform ist die Dekorschicht mit einer Lichtleiterschicht hinterspritzt.

Die JP 2010 165618 A beschreibt ebenfalls das Hinterspritzen einer Folie mit einer Lichtleiterschicht.

Die US 2011/0012845 beschreibt Strukturen von Berührungssensoren für Displays. Gemäß Fig. 13 wird die elektrische Verbindung zwischen einer Leiterplatte und einer Sensorfläche mittels eines Tails hergestellt.

Vor diesem Hintergrund war es Aufgabe der vorliegenden Erfindung, ein Haushaltsgerät mit einem kapazitiven Bedienpanel bereitzustellen, das leicht und bequem zu bedienen ist und dabei insbesondere auf vereinfachte Weise herzustellen ist. Aufgabe der Erfindung war es außerdem, ein Verfahren zur Herstellung dieses Haushaltsgerätes bereitzustellen.

Die Lösung dieser Aufgabe wird nach dieser Erfindung erreicht durch ein Haushaltsgerät sowie ein Verfahren zu seiner Herstellung mit den Merkmalen der jeweiligen unabhängigen Patentansprüche. Bevorzugte Ausführungsformen des erfindungsgemäßen Haushaltsgeräts sind in entsprechenden abhängigen Patentansprüchen aufgeführt.

Gegenstand der Erfindung ist somit ein Haushaltsgerät mit einer Steuereinrichtung, einer mindestens teilweise lichtdurchlässigen Blende sowie mit einem mindestens teilweise lichtdurchlässigen Bedienpanel mit mindestens einem kapazitiven Sensor zur Auswahl einer Programmfunktion des Haushaltsgerätes durch einen Benutzer des Gerätes, wobei das Bedienpanel ein aus mehreren Schichten bestehendes Kunststoffbauteil aufweist, umfassend
(a) eine Anzeigedisplayfolie;
(b) eine berührungsempfindliche Folie, welche den mindestens einen kapazitiven Sensor sowie elektrische Leiterbahnen aufweist; und
(c) eine strukturierte Lichtleiterschicht, die aus Polycarbonat besteht oder Polycarbonat umfasst;
wobei die Anzeigedisplayfolie sowie die berührungsempfindliche Folie flexible Kunststofffolien aus PET (Polyethylenterephthalat), Polyethylen, Polypropylen, Polyetheretherketon, Polycarbonat, Polyoxymethylen oder ABS sind, und
wobei das Kunststoffbauteil erhältlich ist durch Verbinden einer selbstklebenden Anzeigedisplayfolie mit der berührungsempfindlichen Folie und ein anschließendes Hinterspritzen der strukturierten Lichtleiterschicht.

Die Anzeigedisplayfolie sowie die berührungsempfindliche Folie bestehen neben den zur Beschichtung verwendeten Materialien jeweils aus einer Kunststofffolie, wobei diese Folien flexible Kunststofffolien aus PET (Polyethylenterephthalat), Polyethylen, Polypropylen, Polyetheretherketon, Polycarbonat, Polyoxymethylen oder ABS sind.

Außerdem weisen die Anzeigedisplayfolie und die berührungsempfindliche Folie jeweils vorzugsweise eine Dicke von 5 bis 500 µm auf, insbesondere von 25 bis 200 µm.

Der mindestens eine kapazitive Sensor sowie die elektrischen Leiterbahnen können auf unterschiedlichste Weise auf die berührungsempfindliche Folie aufgebracht werden.

Die Beschichtungstechniken für die berührungsempfindliche Folie wie auch die Anzeigedisplayfolie sind nicht besonders eingeschränkt, solange eine ausreichende Haftung auf der berührungsempfindlichen Folie wie auch auf der Anzeigedisplayfolie, insbesondere auch während der Herstellung des Kunststoffbauteils, umfassend die Komponenten (a), (b) und (c), gewährleistet ist.

In einer bevorzugten Ausführungsform der Erfindung sind allerdings der mindestens eine kapazitive Sensor sowie die elektrischen Leiterbahnen auf die berührungsempfindliche Folie gedruckt. Die Drucktechniken sind nicht besonders eingeschränkt. Vorzugsweise wird jedoch Siebdruck angewandt. In einer bevorzugten Ausführungsform ist daher das Drucken durch Siebdruck erfolgt.

Neben metallischen leitenden Strukturen können auf den erfindungsgemäß eingesetzten Folien auch organische leitende Strukturen eingesetzt werden. Im Allgemeinen umfassen daher der mindestens eine kapazitive Sensor und/oder die elektrischen Leiterbahnen ein intrinsisch leitfähiges organisches Polymer oder ein metallisches Leitmaterial oder bestehen aus diesem.

Sofern ein metallisches Leitmaterial erzeugt werden soll, werden vorzugsweise metallhaltige Leitpasten eingesetzt und aufgedruckt.

Intrinsisch leitfähige organische Polymere sind Polymere, die über ein konjugiertes Elektronensystem verfügen und insbesondere im oxidierten Zustand eine deutlich höhere elektrische Leitfähigkeit zeigen als im neutralen Zustand. Beispiele hierfür sind Polythiophen, Polypyrrol, Polyparaphenylen und Polyvinylenphenylen sowie deren substituierte Abkömmlinge. Bei Verwendung dieser Materialien können auf einfache und sichere Weise beispielsweise polymere organische Elektronikbauteile wie Dioden, Transistoren, Kondensatoren oder Sensoren hergestellt werden, aber auch integrierte Schaltkreise. Dabei haben diese Materialien den Vorteil, dass sie durch Drucken auf Kunststofffolien aufgebracht werden können.

Das Material der berührungsempfindlichen Folie ist nicht eingeschränkt, solange eine ausreichende Lichtdurchlässigkeit bereitgestellt werden kann. Vorzugsweise besteht die berührungsempfindliche Folie aus Polyethylenterephthalat.

Die Signale der kapazitiven Sensoren müssen ausgewertet werden, damit über diese eine Steuerung des Haushaltgerätes stattfinden kann. Hierzu sind die Sensoren im Allgemeinen mit einer entsprechenden Auswerteelektronik verbunden. Diese befindet sich im Allgemeinen auf einer dem Bedienpanel benachbarten Leiterplatte.

In einer bevorzugten Ausführungsform der Erfindung ist die berührungsempfindliche Folie über ein flaches Anschlussteil, das hierin auch als Tail bezeichnet wird, also über einen flachen Tail, der Leiterbahnen und/oder Verbindungspads (connector pads) aufweist, mit einer Leiterplatte verbunden. Auf der Leiterplatte sind vorzugsweise Stecker, Leuchtdioden und/oder die Auswertelektronik für Berührungen der berührungsempfindlichen Folie angeordnet.

Das Material der Anzeigedisplayfolie ist nicht besonders eingeschränkt, solange auf dieser Symbole zur Kennzeichnung von Abläufen oder Zuständen im Haushaltsgerät aufgebracht werden können. Im Allgemeinen wird durch eine geeignete Beschichtung auch sichergestellt, dass nur der für eine Anzeige von Informationen vorgesehene Bereich von einem Leuchtmittel beleuchtet werden kann.

Die Beschichtung kann dabei in Form von Linien, Mustern, Bahnen, Symbolen, Zeichen und dergleichen aufgebracht werden, z.B. als Siebdrucklack, der anschließend getrocknet wird.

Vorzugsweise, ist die Anzeigedisplayfolie eine Streufolie, welche Ausnehmungen für anzuzeigende Symbole aufweist. Da beispielsweise LEDs weitestgehend nur punktuelles Licht liefern, sorgt die Folie dafür, dass dieses Licht gestreut wird und somit die Beleuchtung gleichmäßig und gut ablesbar wird. Ganz besonders bevorzugt besteht die Anzeigedisplayfolie aus Polycarbonat, auf dem noch geeignete Lackschichten oder mittels Lacken darstellbare Symbole aufgedruckt sein können.

Im erfindungsgemäßen Haushaltsgerät wird im Allgemeinen im Bedienpanel ein Display mit verschiedenen Symbolen beleuchtet. Hierzu kann das Licht eines geeigneten Leuchtmittels hinter oder seitlich zum Bedienpanel angeordnet sein. Vorzugsweise weist das Bedienpanel auf der der berührungsempfindlichen Folie abgewandten Seite der strukturierten Lichtleiterschicht mindestens ein Leuchtmittel auf.

Das Leuchtmittel ist erfindungsgemäß nicht eingeschränkt. Vorzugsweise werden eine oder mehrere Leuchtdioden eingesetzt.

Es können sowohl anorganische Leuchtdioden als auch organische Leuchtdioden eingesetzt werden. Die Leuchtdioden können als Top-LEDs oder als Side-LEDs vorliegen.

Hierbei können neben den bekannten anorganischen Leuchtdiodenmaterialien organische Leuchtdioden eingesetzt werden. Organische Leuchtdioden benutzen im Allgemeinen kleine organische Moleküle (SM-OLEDs) oder organische Polymere (PLEDs). SM-OLEDs umfassen beispielsweise organometallische Chelate und konjugierte Dendrimere. PLEDs umfassen elektrisch leitfähige Polymere wie z.B. Polythiophene, Polypyrrole, Polyfluorene und Poly-(p-phenylenvinylene), die ggf. geeignet substituiert sein können. Bevorzugte Substituenten sind Alkyl- und Alkoxygruppen.

Der Vorteil von PLEDs ist die Möglichkeit, diese als flexible Filme, erhalten beispielsweise durch Elektropolymerisation der entsprechenden Monomere, Spincoaten oder Drucken (Siebdruck) der Polymere, einzusetzen, wobei außerdem der Strombedarf für die PLEDs relativ gering ist.

In einer besonders bevorzugten Ausführungsform der Erfindung weist das Bedienpanel auf der der berührungsempfindlichen Folie abgewandten Seite der strukturierten Lichtleiterschicht mindestens eine Leuchtdiode auf.

Die Anzahl der eingesetzten Leuchtmittel, z.B. Leuchtdioden, kann erfindungsgemäß sehr variieren, wobei auch mit unterschiedlichen Farben leuchtende Leuchtdioden eingesetzt werden können, um beispielsweise mehrere Informationen anzuzeigen.

Das erfindungsgemäße Haushaltsgerät weist eine lichtdurchlässige Blende aus. Vorzugsweise besteht die lichtdurchlässige Blende zumindest in einem lichtdurchlässigen Bereich der Blende aus Glas, Glaskeramik oder einem Kunststoff.

Gegenstand der Erfindung ist außerdem auch ein Verfahren zur Herstellung eines Haushaltsgerätes mit einer Steuereinrichtung, einer mindestens teilweise lichtdurchlässigen Blende sowie mit einem mindestens teilweise lichtdurchlässigen Bedienpanel mit mindestens einem kapazitiven Sensor zur Auswahl einer Programmfunktion des Haushaltsgerätes durch einen Benutzer des Gerätes, wobei das Bedienpanel ein aus mehreren Schichten bestehendes Kunststoffbauteil aufweist, umfassend
(a) eine Anzeigedisplayfolie;
(b) eine berührungsempfindliche Folie, welche den mindestens einen kapazitiven Sensor sowie elektrische Leiterbahnen aufweist; und
eine strukturierte Lichtleiterschicht, die aus Polycarbonat besteht oder Polycarbonat umfasst; wobei die Anzeigedisplayfolie sowie die berührungsempfindliche Folie flexible Kunststofffolien aus PET (Polyethylenterephthalat), Polyethylen, Polypropylen, Polyetheretherketon, Polycarbonat, Polyoxymethylen oder ABS sind, und wobei das Kunststoffbauteil erhalten wird durch Durchführen der Schritte
(i) Verbinden einer selbstklebenden Anzeigedisplayfolie mit der berührungsempfindlichen Folie; und
(ii) ein anschließendes Hinterspritzen der berührungsempfindlichen Folie mit einem lichtleitenden Kunststoff, um eine strukturierte Lichtleiterschicht zu erhalten.

Vorzugsweise wird ein im Schritt (i) erhaltenes Laminat aus der Anzeigedisplayfolie und der berührungsempfindlichen Folie in ein Formwerkzeug einer Spritzgussmaschine eingeführt und anschließend das Hinterspritzen mit einer viskosen Masse des lichtleitenden Kunststoffes durchgeführt.

Zuvor wird die Anzeigedisplayfolie im Allgemeinen durch geeignete Beschichtung mit lichtundurchlässigen Substanzen, z.B. Lacken, so ausgestaltet, dass sie die für ihren Gebrauch erforderlichen Symbole sowie lichtdurchlässigen Bereiche aufweist.

Außerdem ist es im Allgemeinen erforderlich, die berührungsempfindliche Folie, die aus einem Kunststoff besteht, geeignet mit einem der oben erwähnten leitfähigen Materialien zu strukturieren.

Dies kann beispielsweise gemäß der WO 2007/090586 A durch ein Verfahren mit den Verfahrensschritten
(A) Bereitstellen eines ersten Trägersubstrates, z.B. einer PolyethylenterephthalatFolie als Trägersubstrat bzw. Trägerfolie;
(B) Partielles Bedrucken oder Beschichten des Trägersubstrats mit einem auf dem Trägersubstrat nur schwach haftenden Lack;
(C) Aufbringen einer vollflächigen metallischen Schicht;
(D) Kaschieren gegen ein klebebeschichtetes zweites Trägersubstrat und
(E) Ablösen dieses zweiten klebebeschichteten Trägersubstrates
erreicht werden. Bei dieser Vorgehensweise wird der schwach haftende Lack mit der darüber liegenden metallischen Schicht vom ersten Trägersubstrat abgelöst, so dass eine strukturierte metallische Schicht auf dem ersten Trägersubstrat zurückbleibt.

Daneben können strukturierte Schichten auch dadurch hergestellt werden, dass ein zunächst vollständig beschichtetes Substrat entsprechend einem zu erzielenden metallischen leitfähigen Muster mit einem geeigneten Ätzmedium behandelt wird. Ggf. kann eine vollflächig aufgebrachte Schicht auch durch Laserablation strukturiert werden.

Die Erfindung hat mehrere Vorteile. So ist es möglich, auf einfache Weise einer Bedienperson Auswahl und Durchführung eines im Haushaltsgerät durchzuführenden Programmes darzustellen. Überdies ermöglicht die Erfindung eine verbesserte Darstellung von Informationen über Programmauswahl und -ablauf, da eine verbesserte optische Darstellung möglich ist. Es kann eine Bereitstellung von Informationen über den Betrieb eines Haushaltsgerätes erfolgen, welche es einem Benutzer ermöglichen, die Arbeitsweise des Haushaltsgerätes einzustellen, zu beeinflussen und zu überwachen.

Insbesondere ermöglicht die Erfindung aber die Herstellung eines Haushaltsgerätes mit einer vereinfachten Montage eines Bedienpanels. Die Anzahl der Montageschritte ist verringert. Außerdem ermöglicht es die Erfindung, dass ein Tail zum Stecken nicht mehr durch die Leiterplatte geführt werden muss und auf einer Leiterplatte durch den Wegfall eines Durchführungsschlitzes für das Tail ein geringerer Platzverlust auftreten kann. In Ausführungsformen der Erfindung ist es überdies möglich, dass eine durch die Anordnung der Stecker verursachte zweiseitige Bestückung der Leiterplatte unterbleiben kann. Dieser Aufbau kann auch bei einer sogenannten Huckepacklösung, bei der die Power Unit (PU) hinter einer Operating Unit (OU) angeordnet ist, realisiert werden, da beispielsweise das Tail nicht mehr auf der Rückseite der Operating Unit gesteckt werden muss.

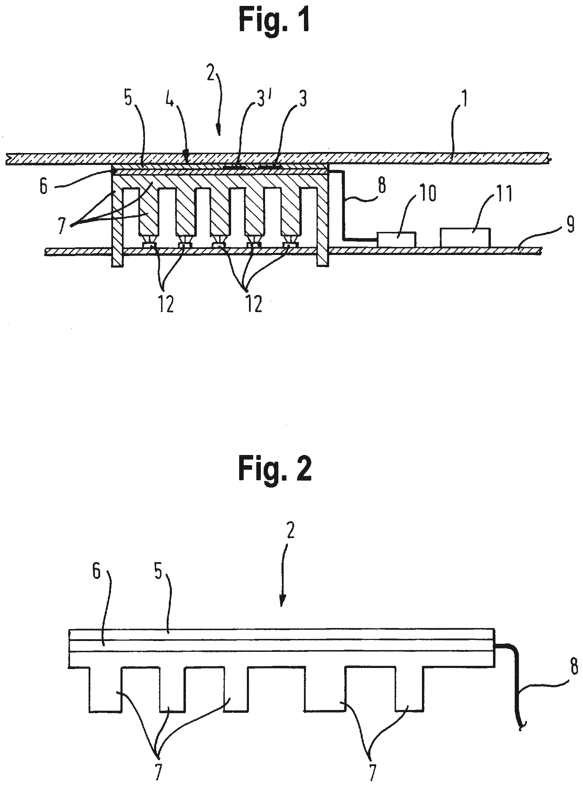

Die Erfindung wird im Folgenden anhand der Figuren 1 und 2 illustriert, in denen zur Vereinfachung lediglich die erfindungsgemäß relevanten Teile eines erfindungsgemäßen Haushaltsgerätes dargestellt sind.
Fig. 1 zeigt einen Ausschnitt aus einem nicht näher dargestellten Haushaltsgerät, der neben einer mindestens teilweise lichtdurchlässigen Blende ein mindestens teilweise lichtdurchlässiges Bedienpanel erkennen lässt.
Fig. 2 zeigt im Wesentlichen einen vergrößerten Ausschnitt aus Fig. 1, in dem das aus mehreren Schichten bestehende Kunststoffbauteil im Bedienpanel näher dargestellt ist.

In Fig. 1 ist hinter einer teilweile lichtdurchlässigen Blende 1 ein Bedienpanel 2 mit zwei kapazitiven Sensoren 3 und 3' angeordnet, welche Berührungen eines Benutzers des Haushaltsgerätes erfassen können, die ausgewertet und über die Steuereinrichtung des Haushaltsgerätes zur Veranlassung von Programmen oder Programmschritten herangezogen werden können.

Das Bedienpanel 2 weist ein Kunststoffbauteil 4 auf, das eine Anzeigedisplayfolie 5 aus Polyethylenterephthalat (PET) sowie eine berührungsempfindliche Folie 6, welche die beiden kapazitiven Sensoren 3 und 3' aufweist, umfasst. Das Kunststoffbauteil 4 wurde dadurch hergestellt, dass eine selbstklebende Anzeigedisplayfolie 5 mit der berührungsempfindlichen Folie 6 laminiert wurde. Anschließend wurde das Laminat in das Formwerkzeug einer Spritzgußmaschine eingebracht und mit einer viskosen Polycarbonat-Masse eine strukturierte Lichtleiterschicht 7 aufgebracht. Dabei erfolgte die Strukturierung der Lichtleiterschicht 7 derart, dass das Lichtleitermaterial, d.h. Polycarbonat, so angeordnet wurde, dass Licht aus Leuchtdioden 12 leicht in dieses gelangen kann. Die Leuchtdioden 12 sind bei der hier gezeigten Ausführungsform auf einer Leiterplatte 9 angeordnet, auf der sich auch ein Stecker 10 sowie eine elektronische Auswerteeinheit 11 für die Berührungen der berührungsempfindlichen Folie 6 befinden. Ein Tail 8 verbindet die berührungsempfindliche Folie 6 mit dem Stecker 10 auf der Leiterplatte 9.

In Fig. 2 wird als im Wesentlichen vergrößerter Ausschnitt aus Fig. 1 das aus mehreren Schichten bestehende Kunststoffbauteil 4 im Bedienpanel 2 näher gezeigt. Insbesondere ist hier erkennbar, dass die Lichtleiterschicht 7 so strukturiert ist, dass Ausbuchtungen in die Richtung von hier nicht dargestellten Leuchtdioden zeigen.

### Bezugszeichenliste

- 1: Mindestens teilweise lichtdurchlässige Blende
- 2: Mindestens teilweise lichtdurchlässiges Bedienpanel
- 3 3': Kapazitiver Sensor
- 4: Kunststoffbauteil
- 5: Anzeigedisplayfolie
- 6: Berührungsempfindliche Folie
- 7: Strukturierte Lichtleiterschicht
- 8: Tail, umfassend Leiterbahnen und/oder Verbindungspads
- 9: Leiterplatte
- 10: Stecker
- 11: Auswerteelektronik
- 12: Leuchtdioden

## Patentansprüche

1. Haushaltsgerät mit einer Steuereinrichtung, einer mindestens teilweise lichtdurchlässigen Blende (1) sowie mit einem mindestens teilweise lichtdurchlässigen Bedienpanel (2) mit mindestens einem kapazitiven Sensor (3,3') zur Auswahl einer Programmfunktion des Haushaltsgerätes durch einen Benutzer des Gerätes, wobei das Bedienpanel (2), das hinter der Blende angelegt ist, ein aus mehreren Schichten bestehendes Bauteil (4) aufweist, umfassend
(a) eine Anzeigedisplayfolie (5);
(b) eine berührungsempfindliche Folie (6), welche den mindestens einen kapazitiven Sensor (3,3') sowie elektrische Leiterbahnen aufweist; und
(c) eine strukturierte Lichtleiterschicht (7), **dadurch gekennzeichnet, dass** das Bauteil ein Kunststoffbauteil ist und dass die strukturierte Lichtleiterschicht aus Polycarbonat besteht oder Polycarbonat umfasst;
wobei die Anzeigedisplayfolie selbstklebend ist;
wobei die Anzeigedisplayfolie (5) sowie die berührungsempfindliche Folie (6) flexible Kunststofffolien aus PET (Polyethylenterephthalat), Polyethylen, Polypropylen, Polyetheretherketon, Polycarbonat, Polyoxymethylen oder ABS sind, und wobei das Kunststoffbauteil (4) so angepasst ist, dass es erhältlich ist durch Verbinden der selbstklebenden Anzeigedisplayfolie (5) mit der berührungsempfindlichen Folie (6) und ein anschließendes Hinterspritzen der strukturierten Lichtleiterschicht (7).

2. Haushaltsgerät nach Anspruch 1, **dadurch gekennzeichnet, dass** der mindestens eine kapazitive Sensor (3,3') sowie die elektrischen Leiterbahnen auf die berührungsempfindliche Folie (6) gedruckt sind.

3. Haushaltsgerät nach Anspruch 2, **dadurch gekennzeichnet, dass** das Drucken durch Siebdruck erfolgt ist.

4. Haushaltsgerät nach einem der Ansprüche 1 bis 3, **dadurch gekennzeichnet, dass** der mindestens eine kapazitive Sensor (3,3') und/oder die elektrischen Leiterbahnen ein intrinsisch leitfähiges organisches Polymer oder ein metallisches Leitmaterial umfassen oder aus diesem bestehen.

5. Haushaltsgerät nach einem der Ansprüche 1 bis 4, **dadurch gekennzeichnet, dass** das Bedienpanel (2) auf der der berührungsempfindlichen Folie (6) abgewandten Seite der strukturierten Lichtleiterschicht (7) mindestens eine Leuchtdiode (12) aufweist.

6. Haushaltsgerät nach einem der Ansprüche 1 bis 5, **dadurch gekennzeichnet, dass** die berührungsempfindliche Folie (6) aus Polyethylenterephthalat besteht.

7. Haushaltsgerät nach einem der Ansprüche 1 bis 6, **dadurch gekennzeichnet, dass** die berührungsempfindliche Folie (6) über einen flachen Tail (8), der Leiterbahnen und/oder Verbindungspads (connector pads) aufweist, mit einer Leiterplatte (9) verbunden ist.

8. Haushaltsgerät nach Anspruch 7, **dadurch gekennzeichnet, dass** auf der Leiterplatte (9) Stecker (10), Leuchtdioden (12) und/oder die Auswertelektronik (11) für Berührungen der berührungsempfindlichen Folie (6) angeordnet sind.

9. Haushaltsgerät nach einem der Ansprüche 1 bis 8, **dadurch gekennzeichnet, dass** die Anzeigedisplayfolie (5) eine Streufolie ist, welche Ausnehmungen für anzuzeigende Symbole aufweist.

10. Haushaltsgerät nach Anspruch 9, **dadurch gekennzeichnet, dass** die Anzeigedisplayfolie (5) aus Polycarbonat besteht.

11. Haushaltsgerät nach einem der Ansprüche 1 bis 10, **dadurch gekennzeichnet, dass** die lichtdurchlässige Blende (1) zumindest in einem lichtdurchlässigen Bereich der Blende (1) aus Glas, Glaskeramik oder einem Kunststoff besteht.

12. Verfahren zur Herstellung eines Haushaltsgerätes mit einer Steuereinrichtung, einer mindestens teilweise lichtdurchlässigen Blende (1) sowie mit einem mindestens teilweise lichtdurchlässigen Bedienpanel (2) mit mindestens einem kapazitiven Sensor (3,3') zur Auswahl einer Programmfunktion des Haushaltsgerätes durch einen Benutzer des Gerätes, wobei das Bedienpanel (2), das hinter der Blende angelegt ist, ein aus mehreren Schichten bestehendes Bauteil (4) aufweist, umfassend
(a) eine Anzeigedisplayfolie (5);
(b) eine berührungsempfindliche Folie (6), welche den mindestens einen kapazitiven Sensor (3,3') sowie elektrische Leiterbahnen aufweist; und
(c) eine strukturierte Lichtleiterschicht (7); **dadurch gekennzeichnet**, das das Bauteil ein Kunststoffbauteil ist und die strukturierte Lichtleiterschicht aus Polycarbonat besteht oder Polycarbonat umfasst, wobei die Anzeigedisplayfolie selbstklebend ist
und wobei die Anzeigedisplayfolie (5) sowie die berührungsempfindliche Folie (6) flexible Kunststofffolien aus PET (Polyethylenterephthalat), Polyethylen, Polypropylen, Polyetheretherketon, Polycarbonat, Polyoxymethylen oder ABS sind,
wobei das Kunststoffbauteil (4) erhalten wird durch Durchführen der Schritte
(i) Verbinden einer selbstklebenden Anzeigedisplayfolie (5) mit der berührungsempfindlichen Folie (6); und
(ii) ein anschließendes Hinterspritzen der berührungsempfindlichen Folie (6) mit einem lichtleitenden Kunststoff, um eine strukturierte Lichtleiterschicht (7) zu erhalten.

13. Verfahren nach Anspruch 12, **dadurch gekennzeichnet, dass** ein im Schritt (i) erhaltenes Laminat aus der Anzeigedisplayfolie (5) und der berührungsempfindlichen Folie (6) in ein Formwerkzeug einer Spritzgussmaschine eingeführt wird und anschließend das Hinterspritzen mit einer viskosen Masse des lichtleitenden Kunststoffes durchgeführt wird.

## Claims

1. Domestic appliance having a control device, an at least partially translucent fascia (1) and having an at least partially translucent operating panel (2) having at least one capacitive sensor (3,3') allowing a user of the appliance to select a program function of the domestic appliance, wherein the operating panel (2), which is mounted behind the fascia, has a component (4) consisting of multiple layers, comprising
(a) a display film (5);
(b) a touch-sensitive film (6) which has the at least one capacitive sensor (3,3') as well as electrical conductor tracks; and
(c) a structured optical fibre layer (7), **characterised in that** the component is a plastic component and the structured optical fibre layer is made of or comprises polycarbonate;
wherein the display film is self-adhesive;
wherein the display film (5) and the touch-sensitive film (6) are flexible plastic films made of PET (polyethylene terephthalate), polyethylene, polypropylene, polyether ether ketone, polycarbonate, polyoxymethylene or ABS, and wherein the plastic component (4) is adapted such that it can be obtained by bonding the self-adhesive display film (5) to the touch-sensitive film (6) and subsequently applying the structured optical fibre layer (7) by back injection moulding.

2. Domestic appliance according to claim 1, **characterised in that** the at least one capacitive sensor (3,3') and the electrical conductor tracks are printed onto the touch-sensitive film (6).

3. Domestic appliance according to claim 2, **characterised in that** the printing is performed using screen printing.

4. Domestic appliance according to one of claims 1 to 3, **characterised in that** the at least one capacitive sensor (3,3') and/or the electrical conducting tracks comprise or are made of an intrinsically conducting organic polymer or a metallic conductive material.

5. Domestic appliance according to one of claims 1 to 4, **characterised in that** the operating panel (2) has at least one light-emitting diode (12) on the side of the structured optical fibre layer (7) facing away from the touch-sensitive film (6).

6. Domestic appliance according to one of claims 1 to 5, **characterised in that** the touch-sensitive film (6) is made of polyethylene terephthalate.

7. Domestic appliance according to one of claims 1 to 6, **characterised in that** the touch-sensitive film (6) is connected to a printed circuit board (9) by means of a flat tail (8) having conductor tracks and/or connector pads.

8. Domestic appliance according to claim 7, **characterised in that** connectors (10), light-emitting diodes (12) and/or the evaluation electronics (11) for touches on the touch-sensitive film (6) are arranged on the printed circuit board (9).

9. Domestic appliance according to one of claims 1 to 8, **characterised in that** the display film (5) is a diffusion film having recesses for symbols to be displayed.

10. Domestic appliance according to claim 9, **characterised in that** the display film (5) is made of polycarbonate.

11. Domestic appliance according to one of claims 1 to 10, **characterised in that** the translucent fascia (1), at least in a translucent region of the fascia (1), is made of glass, glass ceramic or a plastic.

12. Method for the production of a domestic appliance having a control device, an at least partially translucent fascia (1) and having an at least partially translucent operating panel (2) having at least one capacitive sensor (3,3') allowing a user of the appliance to select a program function of the domestic appliance, wherein the operating panel (2), which is mounted behind the fascia, has a component (4) consisting of multiple layers, comprising
(a) a display film (5);
(b) a touch-sensitive film (6) which has the at least one capacitive sensor (3,3') as well as electrical conductor tracks; and
(c) a structured optical fibre layer (7), **characterised in that**
the component is a plastic component and the structured optical fibre layer is made of or comprises polycarbonate, wherein the display film is self-adhesive and wherein the display film (5) and the touch-sensitive film (6) are flexible plastic films made of PET (polyethylene terephthalate), polyethylene, polypropylene, polyether ether ketone, polycarbonate, polyoxymethylene or ABS, wherein the plastic component (4) is obtained by performing the steps of
(i) bonding the self-adhesive display film (5) to the touch-sensitive film (6); and
(ii) subsequently back injection moulding a translucent plastic onto the touch-sensitive film (6) in order to obtain a structured optical fibre layer (7).

13. Method according to claim 12, **characterised in that** a laminate obtained in step (i) consisting of the display film (5) and the touch-sensitive film (6) is introduced into a forming die of an injection moulding machine, and a viscous mass of the translucent plastic is subsequently back injection moulded.

## Revendications

1. Appareil électroménager avec un dispositif de commande, un écran (1) au moins partiellement transparent ainsi qu'avec un tableau de commande (2) au moins partiellement transparent avec au moins un détecteur capacitif (3, 3') pour la sélection d'une fonction du programme de l'appareil électroménager par un utilisateur de l'appareil, dans lequel le tableau de commande (2), qui est disposé derrière l'écran, comprend un composant (4) constitué de plusieurs couches, comprenant
(a) un film indicateur d'affichage (5) ;
(b) un film sensible au toucher (6), qui comprend ledit au moins un détecteur capacitif (3, 3') ainsi que des pistes conductrices de l'électricité ; et
(c) une couche de guide de lumière (7) structurée,
**caractérisé en ce que** le composant est un composant en matière plastique et **en ce que** la couche de guide de lumière structurée est en polycarbonate ou comprend du polycarbonate ;
dans lequel le film indicateur d'affichage est autoadhésif ;
dans lequel le film indicateur d'affichage (5) ainsi que le film sensible au toucher (6) sont des feuilles de matière plastique souples en PET (téréphtalate de polyéthylène), polyéthylène, polypropylène, polyétheréthercétone, polycarbonate, polyoxyméthylène ou ABS, et dans lequel le composant en matière plastique (4) est apte à être obtenu par liaison du film indicateur d'affichage (5) autoadhésif au film sensible au toucher (6) et à un surmoulage terminal de la couche de guide de lumière (7) structurée.

2. Appareil électroménager selon la revendication 1, **caractérisé en ce que** ledit au moins un détecteur capacitif (3, 3') ainsi que les pistes conductrices de l'électricité sont imprimés sur le film sensible au toucher (6).

3. Appareil électroménager selon la revendication 2, **caractérisé en ce que** l'impression se fait par sérigraphie.

4. Appareil électroménager selon l'une des revendications 1 à 3, **caractérisé en ce que** ledit au moins un détecteur capacitif (3, 3') et/ou les pistes conductrices de l'électricité comprennent ou sont constitués d'un polymère organique intrinsèquement conducteur ou d'une matière conductrice métallique.

5. Appareil électroménager selon l'une des revendications 1 à 4, **caractérisé en ce que** le tableau de commande (2) comprend, du côté opposé au film sensible au toucher (6) de la couche de guide de lumière (7) structurée, au moins une diode électroluminescente (12).

6. Appareil électroménager selon l'une des revendications 1 à 5, **caractérisé en ce que** le film sensible au toucher (6) est constitué de téréphtalate de polyéthylène.

7. Appareil électroménager selon l'une des revendications 1 à 6, **caractérisé en ce que** le film sensible au toucher (6) est relié à une plaque conductrice (9) par une bande (8) qui comprend des pistes conductrices et/ou des plages de connexion.

8. Appareil électroménager selon la revendication 7, **caractérisé en ce que** sur la plaque conductrice (9) sont disposés des plots (10), des diodes électroluminescentes (12) et/ou l'électronique d'évaluation (11) des contacts sur le film sensible au toucher (6).

9. Appareil électroménager selon l'une des revendications 1 à 8, **caractérisé en ce que** le film indicateur d'affichage (5) est une feuille de diffusion qui comprend des évidements pour des symboles d'affichage.

10. Appareil électroménager selon la revendication 9, **caractérisé en ce que** le film indicateur d'affichage (5) est constitué de polycarbonate.

11. Appareil électroménager selon l'une des revendications 1 à 10, **caractérisé en ce que** l'écran transparent (1) est constitué, au moins dans une zone transparente de l'écran (1), de verre, de vitrocéramique ou d'une matière plastique.

12. Procédé de fabrication d'un appareil électroménager avec un dispositif de commande, un écran (1) au moins partiellement transparent, ainsi qu'avec un tableau de commande (2) au moins partiellement transparent avec au moins un détecteur capacitif (3, 3') pour la sélection d'une fonction du programme de l'appareil électroménager par un utilisateur de l'appareil, dans lequel le tableau de commande (2), qui est disposé derrière l'écran, comprend un composant (4) constitué de plusieurs couches, comprenant
(a) un film indicateur d'affichage (5) ;
(b) un film sensible au toucher (6), qui comprend ledit au moins un détecteur capacitif (3, 3') ainsi que des pistes conductrices de l'électricité ; et
(c) une couche de guide de lumière (7) structurée ;
**caractérisé en ce que** le composant est un composant en matière plastique et la couche de guide de lumière structurée est en polycarbonate ou comprend du polycarbonate, dans lequel le film indicateur d'affichage est autoadhésif et dans lequel le film indicateur d'affichage (5) ainsi que le film sensible au toucher (6) sont des feuilles de matière plastique souples en PET (téréphtalate de polyéthylène), polyéthylène, polypropylène, polyétheréthercétone, polycarbonate, polyoxyméthylène ou ABS, dans lequel le composant en matière plastique (4) est apte à être obtenu par la mise en oeuvre des étapes suivantes
(i) liaison d'un film indicateur d'affichage (5) autoadhésif avec le film sensible au toucher (6) ; et
(ii) surmoulage terminal du film sensible au toucher (6) avec une matière plastique conductrice de la lumière afin d'obtenir une couche de guide de lumière (7) structurée.

13. Procédé selon la revendication 12, **caractérisé en ce qu'**un stratifié du film indicateur d'affichage (5) et du film sensible au toucher (6) obtenu dans l'étape (i) est introduit dans un moule d'une machine de moulage par injection et enfin le surmoulage est effectué avec une masse visqueuse de la matière plastique conductrice de la lumière.
